(19) Europäisches Patentamt / European Patent Office / Office européen des brevets

(11) **EP 1 906 466 A1**

(12) **EUROPEAN PATENT APPLICATION**

(43) Date of publication:
02.04.2008 Bulletin 2008/14

(51) Int Cl.:
*H01L 41/24* (2006.01)  *H01L 41/09* (2006.01)
*B41J 2/14* (2006.01)  *C23C 14/34* (2006.01)
*C23C 14/08* (2006.01)

(21) Application number: 07018953.5

(22) Date of filing: 26.09.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: 28.09.2006 JP 2006263979

(71) Applicant: **Fujifilm Corporation**
**Minato-ku**
**Tokyo (JP)**

(72) Inventor: **Fujii, Takamichi**
**Ashigarakami-gun**
**Kanagawa-ken (JP)**

(74) Representative: **Klunker . Schmitt-Nilson . Hirsch**
**Winzererstrasse 106**
**80797 München (DE)**

(54) **Piezoelectric film, process of manufacturing the same and piezoelectric element**

(57) A piezoelectric film forming method includes the step of forming on a substrate (20) a piezoelectric film (40) formed by the elements of a target by opposing a target having a composition according to the composition of film (40) to be formed, and releasing the elements from the target by a vapor phase growth method using plasma. The following formulae (1) and (2) or (3) and (4) are satisfied.

$$400 \leq Ts\,(^\circ C) \leq 500 \quad \cdots \quad (1)$$

$$30 \leq D\,(mm) \leq 80 \quad \cdots \quad (2)$$

$$400 \leq Ts\,(^\circ C) \leq 600 \quad \cdots \quad (3)$$

$$30 \leq D\,(mm) \leq 100 \quad \cdots \quad (4)$$

wherein Ts (°C) and D(mm) respectively represent the film-forming temperature and the distance between the substrate (20) and the target.

FIG.11

EP 1 906 466 A1

**Description**

BACKGROUND OF THE INVENTION

Field of the Invention

This invention relates to a process of forming a piezoelectric film by a phase growth method using plasma; a piezoelectric film formed by the process, a piezoelectric element using the piezoelectric film; and a liquid discharge system using the piezoelectric element.

Description of the Related Art

A piezoelectric element comprising piezoelectric film having piezoelectricity where it is expanded and contracted according to the intensity of an applied electric field and an electrode for applying an electric field to the piezoelectric film has been used, for instance, as an actuator for an inkjet type recording head. As a piezoelectric material, a perovskite oxide having a ferroelectricity such as zircon titanate (PZT) has been known.

The piezoelectric film can be formed by a vapor phase growth method such as sputtering. In the piezoelectric film comprising a Pb-containing perovskite oxide such as PZT, Pb loss is apt to be generated when the piezoelectric film is formed at a high temperature. Accordingly, in the piezoelectric film comprising a Pb-containing perovskite oxide, it is necessary to obtain a film-forming condition under which a perovskite crystal less in the pyrochlore phase is better grown, and the Pb loss is less apt to be generated.

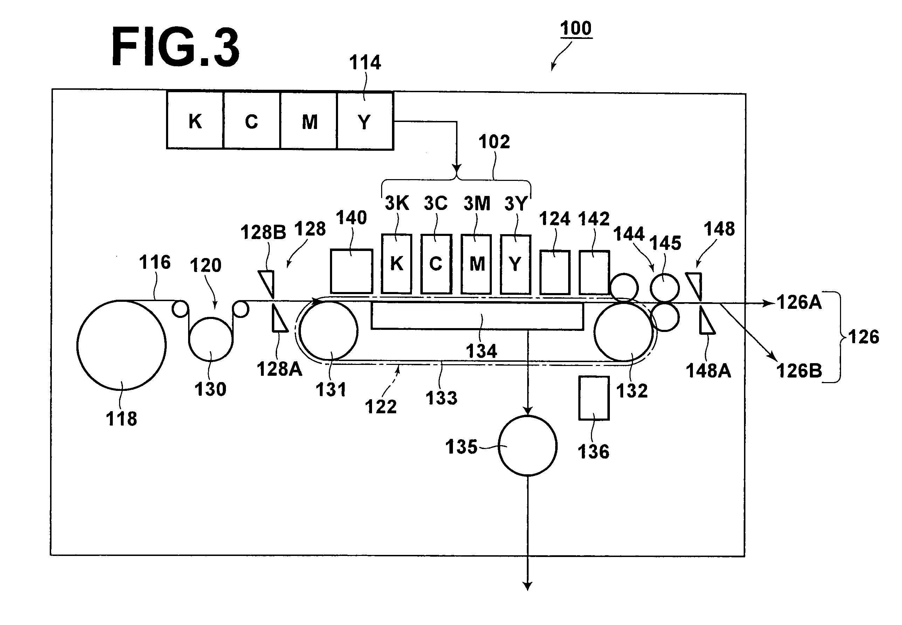

For example, in "Fabrication Process of New Ceramic Thin Films -Epltaxial Growth of Compound Thin Films-", Ceramics, Vol. 21, No.2, pp.119-125, 1986, Preferred film-forming condition of the piezoelectric film is obtained by changing the film-forming temperature with the other conditions fixed. Figure 3 of "Fabrication Process of New Ceramic Thin Films -Epltaxial Growth of Compound Thin Films-", Ceramics, Vol. 21, No.2, pp.119-125, 1986 discloses that when, PbTi03 comprises the pyrochlore phase, when film-forming temperature is about 550 to 700°C, the perovskite crystal grows and when film-forming temperature is not lower than about 700°C, PbTiO3 is non-crystalline.

In Japanese Unexamined Patent Publication No. 6(1994)-049638, the relation between the film-forming pressure and the amount of Pb in the film is obtained. See Figures 1 and 2 of Japanese Unexamined Patent Publication No. 6(1994)-049638. Japanese Unexamined Patent Publication No. 6(1994)-049638 discloses that the film-forming pressure and the film-forming temperature are preferably 1 to 100mTorr and 600 to 700°C, respectively. See Claims 2 and 5 of Japanese Unexamined Patent Publication No. 6(1994)-049638.

As shown in "Fabrication Process of New Ceramic Thin Films -Epltaxial Growth of Compound Thin Films-", Ceramics, Vol. 21, No.2, pp.119-125, 1986 and Japanese Unexamined Patent Publication No. 6(1994)-049638, it is conventionally believed that, in the piezoelectric film comprising a Pb-containing perovskite oxide such as PZT, film-forming temperature of 550 to 700°C is preferable. However, these inventor's investigation has revealed that the perovskite crystal poor in the pyrochlore phase grows and a piezoelectric film exhibiting an excellent piezoelectricity can be obtained even when the film-forming temperature is about 420 to 480°C. Lower film-forming temperature is preferable in preventing the Pb loss.

Irrespective of whether it includes Pb, a stress is applied to the piezoelectric film in the cooling step during or after the film-forming step due to difference in the thermal expansion coefficient between the substrate and the piezoelectric film when the film-forming temperature is high and there is a fear that cracks or the like are generated in the film, whereby lower film-forming temperature is preferable. When the film can be formed at a lower temperature, the substrate may be of a glass or the like which is relatively low in thermal resistance, whereby width in selecting the substrate is increased, which is preferable.

It is conceivable that some factors other than the temperature and the pressure work in forming the piezoelectric film, and when the factors are in a suitable range, a perovskite crystal less in the pyrochlore phase can be grown.

In Japanese Unexamined Patent Publication No. 2005-350735, there is disclosed a method where, in a method of making film of oxide by the sputtering by the use of metal atoms struck out from a target opposed to the substrate, a film-forming condition is controlled so that the average free stroke of the atoms of the target forming metal is longer than the substrate-target distance and that the film of the oxide can be preferentially oriented in a particular orientation by firing the film at a temperature not lower than a certain temperature after formation of the film.

However, the method disclosed in Japanese Unexamined Patent Publication No. 2005-350735 is not practical since the substrate-target distance is as long as 160mm as well as the film is formed with the substrate at a non-elevated temperature, and the film-forming speed is very low, and since a heat treatment or the like is required after the film-forming step. Accordingly, the invention disclosed in Japanese Unexamined Patent Publication No. 2005-350735 does not overcome the problem of the present invention to provide a process of stably and efficiently forming high quality film by a vapor phase growth method using sputtering or the like. When the film-forming speed is too low, it is difficult to grow a high quality crystal.

SUMMARY OF THE INVENTION

In view of the foregoing observations and description, the primary object of the present invention is to clear the factors of the film-forming condition which affect the characteristics of the film in a vapor phase growth method using sputtering or the like, thereby providing a piezoelectric film-forming process of stably and efficiently forming high quality piezoelectric film by a gas phase growth method using sputtering or the like.

More particularly the object of the present invention is to provide a process of forming a piezoelectric film in which a perovskite crystal less in the pyrochlore phase can be stably grown and a piezoelectric film formed by the film-forming method.

The object of the present invention is to provide a process of forming a piezoelectric film comprising a Pb-containing perovskite oxide such as PZT in which a perovskite crystal less in the pyrochlore phase can be stably grown and a generation of the Pb loss can be stably suppressed, and a piezoelectric film formed by the film-forming method.

These inventor's studied hard to reveal that, in the process of forming the piezoelectric film where piezoelectric film comprising the elements of a target is formed on a substrate by releasing the elements from the target having a composition according to the composition of film to be formed, with the target opposed to the substrate, by a vapor phase growth method using plasma such as the sputtering, the characteristics of the piezoelectric film to be formed largely depends upon the film-forming temperature Ts (°C) and the substrate-target distance D (mm) and by optimizing these factors, high quality piezoelectric film can be formed, and completed this invention.

The piezoelectric film forming process of the present invention comprises the step of forming on a substrate, a piezoelectric film comprising the elements of a target by opposing a target having a composition according to the composition of film to be formed, and releasing the elements from the target by a vapor phase growth method using plasma, wherein the following formulae (1) and (2) are satisfied.

$$400 \leq Ts(°C) \leq 500 \quad \cdots \quad (1)$$

$$30 \leq D(mm) \leq 80 \quad \cdots \quad (2)$$

wherein Ts (°C) and D(mm) respectively represent the film-forming temperature and the distance between the substrate and the target.

In this specification, the "film-forming temperature Ts (°C)" means a temperature at the center of the substrate on which the film is to be formed.

In this specification, the "distance between the substrate and the target" is defined to be a distance between the center of the substrate surface facing the target and the target as measured perpendicularly to the target. When film is formed by the use of a plurality of targets, the "distance between the substrate and the target" is the average of the respective the substrate-target distances.

In accordance with the present invention, there is further provided with a second piezoelectric film forming process comprising the step of forming on a substrate, a piezoelectric film comprising the elements of a target by opposing a target having a composition according to the composition of film to be formed, and releasing the elements from the target by a vapor phase growth method using plasma, wherein the following formulae (3) and (4) are satisfied.

$$500 \leq Ts(°C) \leq 600 \quad \cdots \quad (3)$$

$$30 \leq D(mm) \leq 100 \quad \cdots \quad (4)$$

wherein Ts (°C) and D(mm) respectively represent the film-forming temperature and the distance between the substrate and the target.

In the present invention, it is preferred that the film be formed at a film-forming speed not lower than 0.5μm/h.

As the piezoelectric film to which the piezoelectric film forming process of the present invention is applicable, there may be shown piezoelectric film comprising at least one kind of perovskite oxide (may include an unavoidable impurity).

The piezoelectric film forming process of the present invention is applicable to piezoelectric film comprising at least one kind of perovskite oxide (may include an unavoidable impurity) represented by the following general formula (P).

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard.)

The piezoelectric film forming process of the present invention is also applicable to piezoelectric film comprising at least one kind of perovskite oxide (may include an unavoidable impurity) represented by the following general formula (P-1).

$$Pb_a(Zr_{b1}Ti_{b2}X_{b3})O_3 \qquad (P-1)$$

(wherein X represents at least one kind of metal element selected from an element group consisting of the V and VI group elements, and a>0, b1>0, b2>0, b3≥0. Though a=1.0 and b1+b2+b3=1.0 by standard, these values may deviate from 1.0 in the range where perovskite structure is formed.)

The piezoelectric film of the present invention is piezoelectric film comprising at least one kind of perovskite oxide (may include an unavoidable impurity) represented by the following general formula (P) and formed by a vapor phase growth method using plasma where a piezoelectric film comprising the elements of a target is formed by opposing a target having a composition according to the composition of film to be formed, and releasing the elements from the target, wherein the following formulae (1) and (2) are satisfied.

$$400 \leq Ts(°C) \leq 500 \quad \cdots \quad (1)$$

$$30 \leq D(mm) \leq 80 \quad \cdots \quad (2)$$

wherein Ts (°C) and D(mm) respectively represent the film-forming temperature and the distance between the substrate and the target.

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard.)

In accordance with the present invention, there is further provided with a second piezoelectric film comprising at least one kind of perovskite oxide (may include an unavoidable impurity) represented by the following general formula (P) and formed by a gas phase growth method using plasma where a piezoelectric film comprising the elements of a target is formed by opposing a target having a composition according to the composition of film to be formed, and releasing the elements from the target, wherein the following formulae (3) and (4) are satisfied.

$$500 \leq Ts(°C) \leq 600 \quad \cdots \quad (3)$$

$$30 \leq D(mm) \leq 100 \quad \cdots \quad (4)$$

wherein Ts (°C) and D(mm) respectively represent the film-forming temperature and the distance between the substrate and the target.

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, 0 represents an oxygen atom and though the number moles a of the A site elements is 1.0 and the number of moles b of the B site elements is 1.0 by standard, the number of moles of the A site elements and B site elements may deviate from 1.0 in the range where perovskite structure is formed)

The piezoelectric film of the present invention is also applicable to at least one kind of the perovskite oxide represented by the following general formula (P-1).

$$Pb_a(Zr_{b1}Ti_{b2}X_{b3})O_3 \qquad (P-1)$$

(wherein X represents at least one kind of metal element selected from an element group consisting of the V and VI group elements, and a>0, b1>0, b2>0, b3≥0. Though a=1.0 and b1+b2+b3=1.0 by standard, these values may deviate from 1.0 in the range where perovskite structure is formed.)

In accordance with the present invention, a piezoelectric film which is free of the Pb loss and where $1.0 \leq a$, and preferably $1.0 \leq a \leq 1.3$ can be obtained.

The piezoelectric element of the present invention comprises piezoelectric film and an electrode for applying an electric field to the piezoelectric film.

In accordance with the present invention, there is further provided with a liquid discharge system comprising the piezoelectric electric element and a liquid storing/discharging member comprising a liquid storing chamber in which liquid is stored and a liquid discharge port through which the liquid is externally discharged.

The present invention clearly shows that, in the method of forming the piezoelectric film where piezoelectric film comprising the elements of a target is formed on a substrate by releasing the elements from the target having a composition according to the composition of film to be formed, with the target opposed to the substrate, by a vapor phase growth method using plasma such as the sputtering, the characteristics of the piezoelectric film and the film-forming speed to be formed largely depends upon two factors, the film-forming temperature Ts (°C) and the substrate-target distance D (mm).

In accordance with the process of forming the piezoelectric film of the present invention, the film-forming condition is determined on the basis of the relation between the above two factors which affect the characteristics of the film to be formed and the characteristics of the film to be formed. Accordingly, a higher quality piezoelectric film can be stably and more efficiently formed.

Further, in accordance with the present invention, in forming a piezoelectric film comprising perovskite oxide, a perovskite crystal less in the pyrochlore phase can be stably grown. In accordance with the present invention, in forming a piezoelectric film comprising Pb-containing perovskite oxide such as PZT, a perovskite crystal less in the pyrochlore phase can be stably grown and PB loss can be stably suppressed.

BRIEF DESCRIPTION OF THE DRAWINGS

Figure 1A is a cross-sectional view showing an RF sputtering system,
Figure 1B is a schematic view showing formation of film,
Figure 2 is a cross-sectional view of a piezoelectric element and an inkjet recording head (liquid discharge system) in accordance with an embodiment of the present invention,
Figure 3 is a block diagram showing an example of an ink jet recording system provided with an ink jet recording head shown in Figure 2,
Figure 4 is a block diagram showing a part of the ink jet recording system shown in Figure 3, and
Figure 5 is a view showing the relation between the substrate-target distance and the film-forming speed in embodiment 1,
Figure 6 is an XRD pattern of chief piezoelectric film obtained in embodiment 1,
Figure 7 is an XRD pattern of chief piezoelectric film obtained in embodiment 1,
Figure 8 is an XRD pattern of chief piezoelectric film obtained in embodiment 1,
Figure 9 is an XRD pattern of chief piezoelectric film obtained in embodiment 1,
Figure 10 is an XRD pattern of chief piezoelectric film obtained in embodiment 1, and
Figure 11 is a view where the result of XRD measurement is plotted with the film-forming temperature Ts and the substrate-target distance D, respectively taken as the abscissa and the ordinate, for all the samples in the embodiments 1 and 2 and other samples.

DESCRIPTION OF THE PREFERRED EMBODIMENT

(method of forming a film)

The piezoelectric film forming process of the present invention comprises the step of forming on a substrate, a piezoelectric film comprising the elements of a target by opposing a target having a composition according to the composition of film to be formed, and releasing the elements from the target by a gas phase growth method using plasma, wherein the film-forming condition is determined to satisfy the following formulae (1) and (2).

$$400 \leq Ts(°C) \leq 500 \quad \cdots \quad (1)$$

$$30 \leq D(mm) \leq 80 \quad \cdots \quad (2)$$

The second piezoelectric film forming process of the present invention comprises the step of forming on a substrate, a piezoelectric film comprising the elements of a target by opposing a target having a composition according to the composition of film to be formed, and releasing the elements from the target by a gas phase growth method using plasma, wherein the film-forming condition is determined to satisfy the following formulae (3) and (4).

$$500 \leq Ts(°C) \leq 600 \quad \cdots \quad (3)$$

$$30 \leq D(mm) \leq 100 \quad \cdots \quad (4)$$

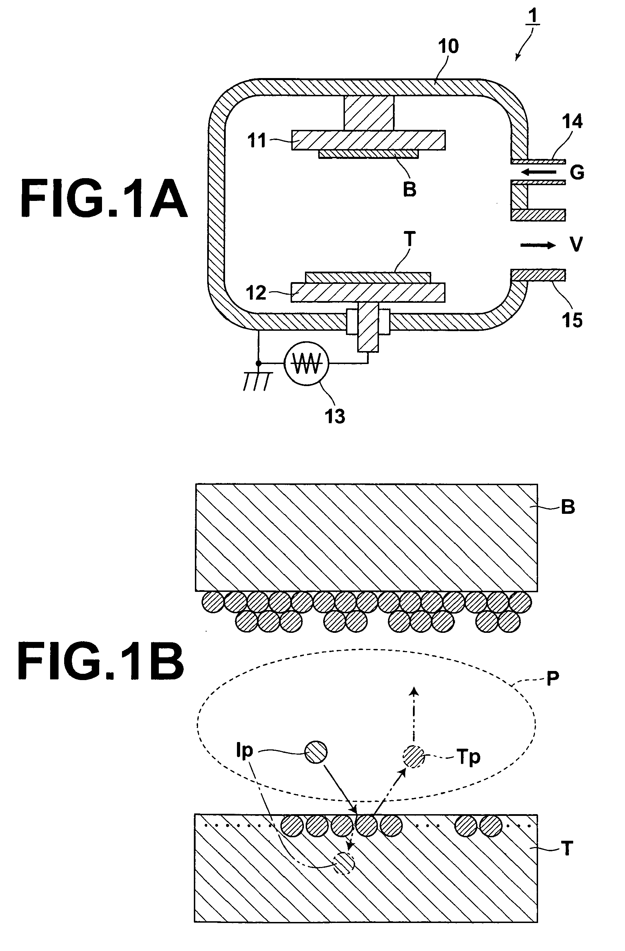

A sputtering system as a film-forming system using plasma will be described with reference to Figures 1A and 1B by way example. Figure 1A is a cross-sectional view showing in brief an RF sputtering system, and Figure 1B is a schematic cross-sectional view showing formation of film.

The RF sputtering system 1 briefly comprises a vacuum chamber 10 having therein a heater 11 on which a substrate B is mounted and which can heat the mounted substrate B to a predetermined temperature and a plasma electrode (cathode electrode) 12 which generates plasma. The heater 11 and the plasma electrode 12 are spaced from each other so that they are opposed to each other and a target T having a composition according to the composition of the film to be formed is mounted on the plasma electrode 12. The plasma electrode 12 is connected to a high frequency power source 13. The substrate B and the target T are spaced from each other (the substrate-target distance) by D(mm).

A gas introduction tube 14 which introduces gas G necessary to form the film into the vacuum chamber 10 and a gas discharge tube 15 which discharge (V) the gas in the vacuum chamber 10 are mounted on the vacuum chamber 10. As the gas G, Ar gas or a Ar/$O_2$ gas mixture or the like is employed. As schematically shown in Figure 1B, the gas G introduced into the vacuum chamber 10 is turned to plasma in response to discharge of the plasma electrode 12 and plus ions Ip such as Ar ions are generated. The generated plus ions Ip sputter the target T. The elements Tp of the target T sputtered by the plus ions Ip are released from the target and deposited on the substrate B in a neutral state or an ionized state. In the drawings, P denotes a plasma space.

It is conceivable that the elements Tp of the target which are between the target T and the substrate B impact against the substrate in forming film with kinetic energy of an acceleration potential corresponding to a potential difference between the plasma space P and the substrate B.

In the vapor phase growth method using plasma, as factors which affect the characteristics of the film to be formed, the film-forming temperature, the kind of the substrate, the composition of the under-film if there is film formed previously, the surface energy of the substrate, the film-forming pressure, the amount of oxygen in the environmental gas, the thrown electrode, the substrate-target distance, the temperature and density of the electrons in the plasma, or the density and life of the active elements in the plasma is conceivable.

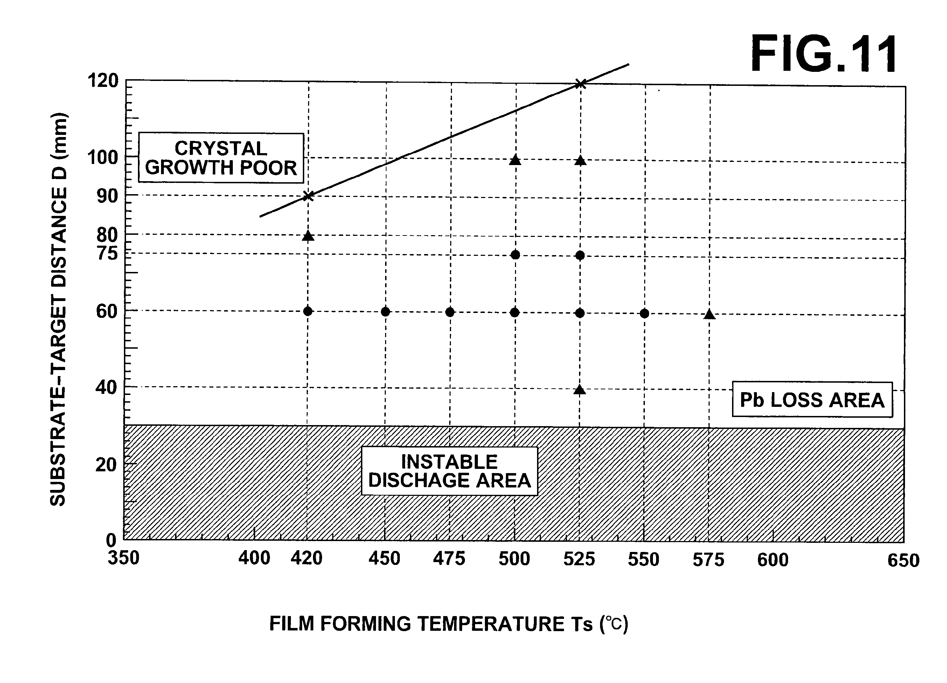

These inventor's have found that in the factors, the characteristics of the piezoelectric film to be formed largely depends upon the film-forming temperature Ts (°C) and the substrate-target distance D (mm) and by optimizing these factors, high quality piezoelectric film can be efficiently formed. That is, these inventor's have found that when the characteristics are plotted with the film-forming temperature Ts and the substrate-target distance D, respectively taken as the abscissa and the ordinate, high quality piezoelectric film can be efficiently formed in a certain range (see Figure 11).

The piezoelectric film to which the film-forming process of the present invention is applicable need not be limited and the film-forming process of the present invention is applicable to piezoelectric film comprising at least one kind of perovskite oxide (may include an unavoidable impurity) represented by the following general formula (P).

$$A_a B_b O_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard.)

As perovskite oxide represented by the above general formula (P), lead-containing compounds such as lead titanate, zircon lead titanate (PZT), lead zirconate, lead titanate lanthanum, lead titanate lanthanum zirconate, magnesium niobate zircon lead titanate, and nickel niobate zircon lead titanate and non-lead-containing compounds such as barium titanate, bismuth sodium titanate, bismuth potassium titanate, sodium niobate, potassium niobate, and lithium niobate can be shown. The piezoelectric film may be have a mixed crystal of these perovskite oxide.

The piezoelectric film-forming process of the present invention is suitably applicable to PZT represented by the following general formula (P-1) or B-site-substituted compounds thereof and compounds having a mixed crystal of these compounds.

$$Pb_a(Zr_{b1}Ti_{b2}X_{b3})O_3 \qquad (P-1)$$

(wherein X represents at least one kind of metal element selected from an element group consisting of the V and VI group elements, and $a>0$, $b1>0$, $b2>0$, $b3\geq0$. Though $a=1.0$ and $b1+b2+b3=1.0$ by standard, these values may deviate from 1.0 in the range where perovskite structure is formed.)

The perovskite oxide represented by the general formula (P-1) is zircon lead titanate (PZT) when $d=0$, and is an oxide where a part of B-site of the PZT is substituted for by X which is at least one kind of metal element selected from an element group consisting of the V and VI group elements when $d>0$.

X may be anyone of metal elements of VA, VB, VIA, VIB group elements, and preferably at least one kind of metal element selected from an element group consisting of V, Nb, Ta, Cr, Mo and W.

These inventor's have revealed that when piezoelectric film comprising the perovskite oxide represented by the general formula P or p-1 is to be formed, a perovskite crystal is not grown well and film which is of a pyrochlore phase in main is formed under the film-forming condition, Ts(°C)<400, where the formula (1) is not satisfied.

These inventor's have further revealed that when piezoelectric film comprising the perovskite oxide represented by the general formula P ore p-1 is to be formed, a perovskite crystal which is less in a pyrochlore phase can be stably grown and the Pb loss can be stably suppressed, whereby piezoelectric film which is of a high quality in crystalline structure and film composition can be stably formed (see Figure 11) by determining the film-forming condition so that the substrate-target distance D satisfies the above formula (2) when 400≤Ts(°C)≤500 and the above formula (1) is satisfied and so that the substrate-target distance D satisfies the above formula (4) when 500≤Ts(°C)≤600 and the above formula (3) is satisfied.

It has been known that the Pb loss is apt to occur when the piezoelectric film is formed at a high temperature in the sputtering. These inventors have further revealed that the Pb loss depends upon the substrate-target distance in addition to the film-forming temperature. In Pb, Zr and Ti forming the PZT, Pb is the most in the sputtering ratio, and is the most apt to be sputtered. For example, table 8. 1. 7 of "Vacuum Handbook" edited by Ulvac Inc. and published by Ω Inc., discloses that the sputtering ratio at 300ev of Ar ions are Pb=0.75, Zr=0.48 and Ti=0.65. That a substance is apt to be sputtered is that the sputtered atom of the substance is apt to be sputtered again after adhering to the surface of the substrate. It is conceivable that as the substrate-target distance is smaller, the sputtering ratio increases and the Pb loss is more apt to be generated. This is real in Pb-containing perovskite oxides other than PZT. Further, this is real in a vapor phase growth method using plasma other than sputtering.

Under the condition where the film-forming temperature TS is too low and the substrate-target distance D is too large, a perovskite crystal tends to be not grown well. Under the condition where the film-forming temperature TS is too high and the substrate-target distance D is too small, the PB loss tends to be apt to be generated.

When 400≤TS≤500 and the above formula (1) is satisfied, it is necessary to relatively shorten the substrate-target distance D in order to better grow the perovskite crystal when the film-forming temperature Ts is relatively low and it is necessary to relatively increase the substrate-target distance D in order to suppress the Pb loss when the film-forming temperature Ts is relatively high. This is represented by the above formula (2). When 500≤TS≤600 and the above formula (3) are satisfied, since the film-forming temperature is relatively high, the same tendency is exhibited though the upper limit of the substrate-target distance D is larger.

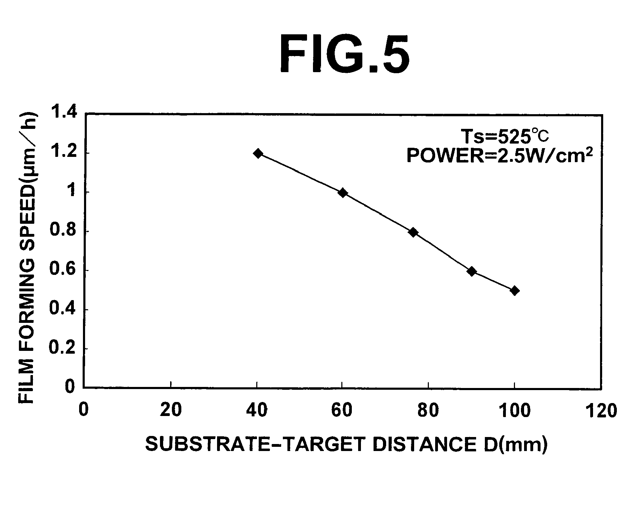

The higher film-forming speed is more preferable from the viewpoint of producing efficiency and is preferably not lower than 0.5μm/h and is more preferably not lower than 1.0μm/h. As shown in Figure 5, the film-forming speed is higher, as the substrate-target distance D is shorter. Figure 5 shows the relation between the film-forming speed and the substrate-target distance D when a PZT film is formed by the use of the RF sputtering system 1. In Figure 5, the film-forming temperature Ts is 525°C and the power (rf power) thrown to the target is 2.5W/cm$^2$. As shown in embodiment 1, a high quality film can be formed even at a high speed not lower than 1.0μm/h in accordance with the present invention.

Depending on the substrate-target distance D, the film-forming speed is lower than 0.5μm/h. In such a case, it is preferred that the power thrown to the target and the like be adjusted so that the film-forming speed becomes not lower than 0.5μm/h.

It is preferred that the substrate-target distance D be as small as possible since the film-forming temperature is higher, as the substrate-target distance D is smaller, and when 400≤TS≤500, it is preferred that the substrate-target distance D be not larger than 80mm, while when 500≤TS≤600, it is preferred that the substrate-target distance D be not larger than 100mm. However, since the plasma is instable when the substrate-target distance D is smaller than 30mm, there is a fear that the film is not formed in a high quality. In order to stably form a higher q1uality film, it is preferred that the substrate-target distance D be 50≤D≤70 either when 400≤TS≤500 or 500≤TS≤600.

We have previously said that the film-forming method disclosed in Japanese Unexamined Patent Publication No. 2005-350735 is not practical since the substrate-target distance is as long as 160mm as well as the film is formed with the substrate at a non-elevated temperature, whereby the film-forming speed is very low, and since a heat treatment (post-firing) or the like is required after the film-forming step. When the film-forming speed is too low, it is difficult to grow a high quality crystal and also in this method, the film formed by the sputtering is not crystallized until the post-firing.

As can be understood from the description above, the substrate-target distance D is determined to be not longer than 100mm in the present invention so that high quality piezoelectric film can be efficiently formed or stably at a high film-forming speed. That is, the substrate-target distance D according to the present invention is shorter than that of the film-forming method disclosed in Japanese Unexamined Patent Publication No. 2005-350735, and accordingly, high quality piezoelectric film can be formed without a post-treatment such as the post-firing.

The present invention clears that the two factors that is, the film-forming temperature Ts(°C) and the substrate-target distance D (mm), affect the characteristics of the film and the film-forming speed in the method of forming the piezoelectric film where piezoelectric film comprising the elements of a target is formed on a substrate by opposing the target having a composition according to the composition of film to be formed, to the substrate and releasing the elements from the target by a gas phase growth method using plasma such as the sputtering.

Since the film-forming conditions are determined on the basis of the two factors which affect the characteristics of the film, higher quality piezoelectric film can be stably and efficiently formed by a gas phase growth method using sputtering or the like.

When the piezoelectric film-forming process in accordance with the present invention is employed, the conditions under which high quality piezoelectric film can be formed are easily found even if a different film-forming system is employed, whereby high quality piezoelectric film can be stably formed.

Further, in accordance with the present invention, in forming a piezoelectric film comprising perovskite oxide, a perovskite crystal less in the pyrochlore phase can be stably grown. In accordance with the present invention, in forming a piezoelectric film comprising Pb-containing perovskite oxide such as PZT, a perovskite crystal less in the pyrochlore phase can be stably grown and PB loss can be stably suppressed.

(piezoelectric film)

By applying the piezoelectric film-forming process of the present invention, the following piezoelectric film of the present invention can be provided.

That is, the piezoelectric film of the present invention is piezoelectric film comprising at least one kind of perovskite oxide (may include an unavoidable impurity) represented by the following general formula (P) and formed by a vapor phase growth method using plasma where a piezoelectric film comprising the elements of a target is formed by opposing a target having a composition according to the composition of film to be formed, and releasing the elements from the target, wherein the film is formed under the film-forming conditions where the following formulae (1) and (2) are satisfied.

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard.)

$$400 \leq Ts(^{\circ}C) \leq 500 \quad \cdots \quad (1)$$

$$30 \leq D(mm) \leq 80 \quad \cdots \quad (2)$$

Further, the piezoelectric film of the present invention is piezoelectric film comprising at least one kind of perovskite oxide (may include an unavoidable impurity) represented by the following general formula (P) and formed by a vapor phase growth method using plasma where a piezoelectric film comprising the elements of a target is formed by opposing a target having a composition according to the composition of film to be formed, and releasing the elements from the target, wherein the film is formed under the film-forming conditions where the following formulae (3) and (4) are satisfied.

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard.)

$$500 \leq Ts(^{\circ}C) \leq 600 \quad \cdots \quad (3)$$

$$30 \leq D(mm) \leq 100 \quad \cdots \quad (4)$$

The present invention is suitably applicable to PZT represented by the following general formula (P-1) or B-site-substituted compounds thereof and compounds having a mixed crystal of these compounds.

$$Pb_a(Zr_{b1}Ti_{b2}X_{b3})O_3 \qquad (P-1)$$

(wherein X represents at least one kind of metal element selected from an element group consisting of the V and VI group elements, and $a>0$, $b1>0$, $b2>0$, $b3 \geq 0$. Though $a=1.0$ and $b1+b2+b3=1.0$ by standard, these values may deviate from 1.0 in the range where perovskite structure is formed.)

In accordance with the present invention, there can be stably provided high quality piezoelectric film which is excellent in crystalline structure and composition and which comprises a perovskite crystal less in the pyrochlore phase and the Pb loss.

In accordance with the present invention, there can be provided piezoelectric film which is $1.0 \leq a$ and free from the Pb loss and at the same time there can be provided Pb-enriched piezoelectric film where $1.0<a$. The upper limit of a need not be limited, and these inventors have found that when $1.0 \leq a \leq 1.3$, there can be provided piezoelectric film which is excellent in piezoelectric performance.

(piezoelectric element and ink jet recording head)

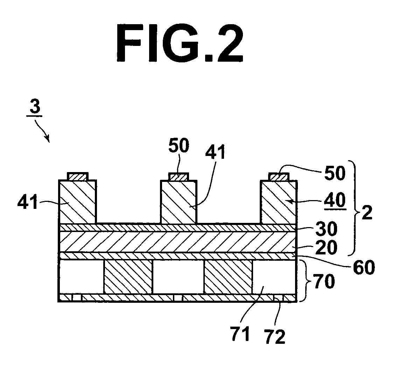

Structure of the piezoelectric element of the present invention, and the ink jet recording head which are provided with the piezoelectric element will be described with reference to Figure 2. Figure 2 is a cross-sectional view of an important part of the ink jet recording head. For the purpose of easiness in viewing, the components are depicted in suitable scales different from the real scales.

The piezoelectric element 2 of this embodiment comprises a lower electrode 30, piezoelectric film 40 and an upper electrode 50 superposed one on another on a substrate 20 in sequence. To the piezoelectric film 40, the electric field is applied in the direction of thickness by the lower and upper electrodes 30 and 50.

The lower electrode 30 is formed over substantially the entire area of the substrate 20, and on the lower electrode 30, is formed the piezoelectric film 40 where the line protrusions 41 each of which extends from this side of Figure 2 to the other side of the lower electrode 30 are arranged in a stripe pattern, and the upper electrode 50 is formed on each of the protrusions 41.

The pattern of the piezoelectric film 40 need not be limited to the illustrated pattern but may be suitably designed.

The piezoelectric film 40 may be continuous. However, it is preferred that the piezoelectric film 40 be formed in a pattern of a plurality of the separate protrusions 41 so that expansion and contraction of each protrusion take place smoothly and a larger displacement can be obtained.

The substrate 20 may be basically formed of any material such as silicon, glass, stainless steel (SUS), yttrium-stabilized zirconia (YSZ), alumina, sapphire, silicon carbide, and the like. The substrate 20 may even comprise a laminated circuit board such as an SOI board where $SiO_2$ oxide film is superposed on the surface of a silicon substrate.

The main component of the lower electrode 30 may basically comprises any material such as metal and metal oxide like Au, Pt, Ir, $IRO_2$, $RuO_2$, $LaNiO_3$ and $SrRuO_3$ and combinations thereof.

The main component of the upper electrode 50 may basically comprises any material such as electrode materials generally used in a semiconductor process like materials shown by way of example in the lower electrode 30, Al, Ta, Cr and Cu and combinations thereof.

The piezoelectric film 40 is piezoelectric film formed by the piezoelectric film-forming method of the present invention described above. Preferably, the piezoelectric film 40 comprises perovskite oxide represented by the above general formula (P).

The thickness of the lower and upper electrodes 30 and 50 basically need not be limited, and, for instance, about 200nm. The thickness of the piezoelectric film 40 basically need not be limited, and normally not smaller than $1\mu m$ and, for instance, 1 to 5 $\mu m$.

The ink jet recording head (liquid discharge system) 3 substantially comprises an ink nozzle (liquid storing/discharging member) 70 which is provided with ink chambers 71 for storing therein ink and an ink discharge port 72 through which ink is externally discharged from the ink chamber 71 and is mounted on the lower surface of the substrate 20 of the piezoelectric element 2 by way of the vibrating plate 60. The ink chambers 71 are provided in a plurality corresponding to the number and the pattern of the protrusion 41 of the piezoelectric film 40.

In the ink jet recording head 3, the intensity of the electric field applied to the protrusions 41 of the piezoelectric element 2 is increased or reduced by the protrusions 4 thereby expanding or contracting the protrusions 4 to control the discharge of the ink from the ink chamber 71.

The piezoelectric element 2 and the ink jet recording head 3 of this embodiment are structured as described above.

(ink jet recording system)

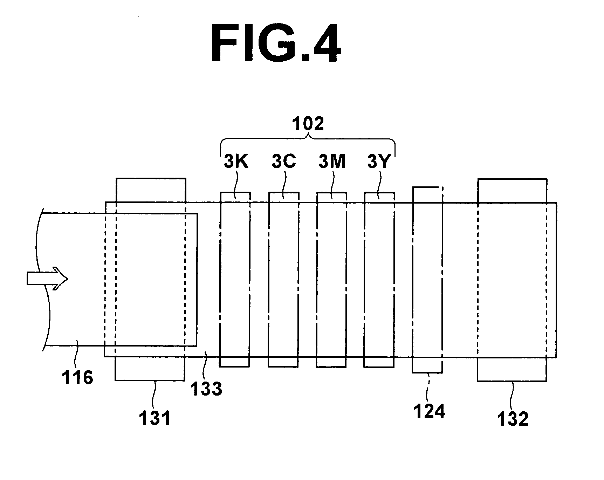

An example of an ink jet recording system provided with an ink jet recording head 3 of the embodiment described above will be described with reference to Figures 3 and 4. Figure 3 is a block diagram showing the overall ink jet recording system, and Figure 4 is a block diagram showing a part of the ink jet recording system.

The ink jet recording system 100 of this embodiment comprises a printing portion 102 having ink jet recording heads 3K, 3C, 3M and 3Y provided for each color of ink, an ink storing/loading portion 114 for storing ink to be supplied to heads 3K, 3C, 3M and 3Y, a paper supply portion 118 for supplying recording papers 116, a decurl portion 120 which removes the curl from the recording papers 116, a suction belt transfer portion 122 which is opposed to a nozzle surface (through which the ink is discharged) of the printing portion 102 and transfers the recording paper 116 while holding the flatness of the recording paper 116, a print detecting portion 124 which detects result of printing by the printing portion 102 and a paper discharge portion 126 which externally discharges printed recording paper (printings).

Each of the heads 3K, 3C, 3M and 3Y forming the printing portion 102 is an ink jet recording head 3 of the above embodiment.

In the decurl portion 120, heat is applied by the heating drum 130 to the recording paper 116 in the direction reverse to the direction in which the recording paper 116 tends to curl, and the recording paper 116 is decurled.

In the system using a rolled paper, a cutter 128 is provided in the stage behind the decurl portion 120 to cut the rolled paper into a desired size as shown in Figure 3. The cutter 128 comprises a stationary blade 128A having a length not shorter than the width of the transfer path of the recording paper 116 and a circular blade 128B which moves along the stationary blade 128A, and the stationary blade 128A is applied to the back side of the recording paper 116 and the circular blade 128B is opposed to the stationary blade 128A with the transfer path of the recording paper 116 intervening therebetween. In the system using cut papers, the cutter 128 is unnecessary.

The decurled and cut recording paper 116 is fed to the suction belt transfer portion 122. The suction belt transfer portion 122 comprises a pair of rollers 131 and 132 and an endless belt 133 passed around the rollers 131 and 132, and at least a part thereof opposed to the nozzle surface and a sensor surface of the print detecting portion 124 of the printing portion 102 is flat.

The belt 133 has a width larger than the width of the recording paper 116 and a number of suction holes (not shown) are formed in the surface of the belt 133. A suction chamber 134 is provided in a position opposed to the nozzle surface and a sensor surface of the print detecting portion 124 of the printing portion 102 inside the belt 133 passed around the rollers 131 and 132, and the recording paper 116 is suctioned and held against the belt 133 by sucking the suction chamber 134 to a negative pressure by a fan 135.

When driving force of a motor (not shown) is transmitted to at least one of the rollers 131 and 132 around which the belt 133 is passed, the belt 133 is driven in the clockwise direction in Figure 3 and the recording paper 116 held on the belt 133 is transferred from the left to the right in Figure 3.

When edgeless prints or the like are printed, ink adheres to the belt 133. Accordingly, a belt cleaning portion 136 is provided to be opposed to the outer side of the belt 133 in a predetermined position (a suitable position outside the printing area).

On the transfer path of the recording paper 116 formed by the suction belt transfer portion 122, a heating fan 140 is provided upstream of the printing portion 102. The heating fan 140 blows heated air to the recording paper 116 before printing to heat the recording paper 116. When the recording paper 116 is heated immediately before printing, ink is apt to be dried after adhering to the recording paper 116.

The ink jet recording system 100 of this embodiment has a so-called full-line type head where the printing portion 102 forms a line type head with a length corresponding to a maximum paper width which is disposed in perpendicular to the paper-feed direction. (See Figure 4) Each of the heads 3K, 3C, 3M and 3Y is formed by a line type head where a plurality of ink discharge ports (nozzle) are arranged over a length exceeding at least one side of a maximum recording paper 116 that is an object of the ink jet recording system 100.

Along the transfer path of the recording paper 116, the heads 3K, 3C, 3M and 3Y corresponding to the inks which are black (K), cyan (C) magenta (M) and yellow (Y) in color are disposed in this order from the upstream. A color image is recorded on the recording paper 116 by discharging the ink from the respective heads 3K, 3C, 3M and 3Y while transferring the recording paper 116.

The print detecting portion 124 comprises a line sensor or the like for taking an image of a result of droplet-shooting by the printing portion 102, and detects a discharge defect such as clogging in the nozzle from a droplet-shooting image read by the line sensor.

Behind the print detecting portion 124, is provided an after drying portion 142 which comprises a heating fan or the like for drying the printed image. Since contact with the printed surface before the ink after printing is dried is preferably avoided, the system where heated air is blown is preferable.

Behind the after drying portion 142, is provided an heating/pressing portion 144 for controlling the glossiness of the image surface. In the heating/pressing portion 144, surface irregularities are transferred to the image surface by pressing the image surface with pressing rollers 145 having predetermined surface irregularities on their surfaces while heating the image surface.

The printings thus obtained are discharged by the paper discharge portion 126. Originally, it is preferred that the running image (image obtained by printing a target image) to be printed be discharged separately from the test printings. In the ink jet recording system 100 of this embodiment, a selecting means (not shown) is provided to separate the running image and the test printings and switches running paths and to feed the running image and the test printings to the respective paper discharge portions 126A and 126B.

When the running image and the test printings are simultaneously printed in parallel, a cutter 148 is provided to sever the test printings.

The ink jet recording system 100 of this embodiment is arranged as described above.

(design change)

The present invention may be suitably changed in the design thereof in the range not to depart from the spirit of the present invention without being limited to the embodiments described above.

(examples)

Embodiments of the present invention and comparative examples will be described, hereinbelow.

(Embodiment 1)

Piezoelectric film comprising PZT or Nb-PZT (Nb-doped PZT) was formed on a substrate under the conditions in a mixed atmosphere of $Ar/O_2$ where the degree of vacuum was 0.5Pa (the volume fraction of $O_2$ was 2.5%) by the sputtering system shown in Figure 1 by the use of a $Pb_{1.3}Zr_{0.52}Ti_{0.48}O_3$ target.

A Ti close contact layer $30\mu m$ thick and an Ir lower electrode 150nm thick were formed on the a Si wafer in sequence, thereby preparing a substrate with electrode as a film-forming substrate.

The piezoelectric films were formed with the film-forming temperature of 525°C and the substrate-target distance D (mm) of 40, 60, 80, 100 and 120mm while an rf power of $2.5W/cm^2$ was applied to the target. At the substrate-target distance D of 60mm, Nb-PZT film was formed and at other D's, PZT film were formed.

Even if the equal rf power is applied to the target, the film-forming speed increases, as the substrate-target distance D is smaller. Figure 5 is a view showing the relation between the substrate-target distance D and the film-forming speed when the film-forming temperature Ts is 525°C while an rf power of 2.5W/cm$^2$ was applied to the target. As shown in Figure 5, when the substrate-target distance D is 60(mm), for instance, the film-forming speed is 1.0$\mu$m/h.

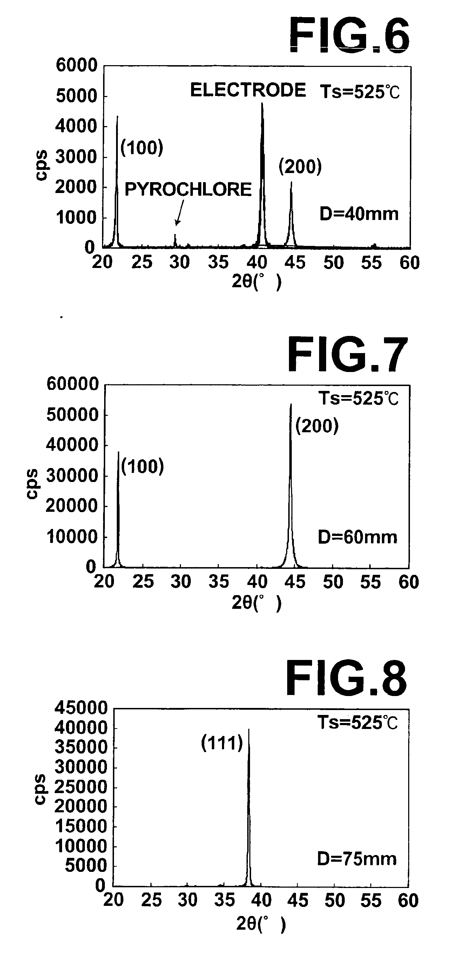

X-ray diffraction analysis (XRD) was carried on each obtained piezoelectric film. XRD pattern of each obtained piezoelectric film is shown in Figures 6 to 10.

As shown in Figures 6 to 10, under the condition where the film-forming temperature Ts is 525°C, a perovskite crystal having a crystalline orientation can be obtained in the range where the substrate-target distance D is 40 to 100mm. Corresponding to Figure 5, the film-forming speed is 0.5$\mu$m/h to 1.2$\mu$m/h and perovskite crystals can be obtained at a high manufacturing efficiency.

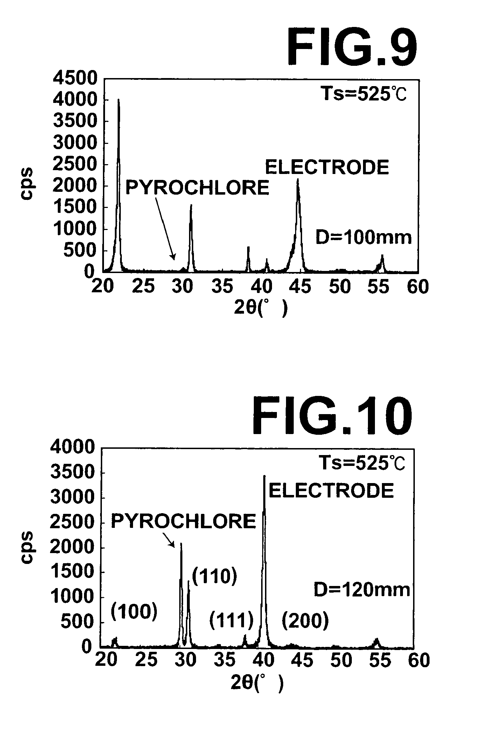

When the substrate-target distance D=120mm (Figure 10), the film mainly including the pyrochlore phase was obtained. Accordingly, this case was determined to be "×". In this case, it is conceivable that the substrate-target distance D is too long to obtain a quick film-forming speed and a sufficient perovskite growth. When the substrate-target distance D=100mm (Figure 9), there has been viewed the pyrochlore phase in other samples prepared under the same condition. Accordingly, this case was determined to be "▲". When the substrate-target distance D=40mm (Figure 6), there has been similarly viewed the pyrochlore phase. Accordingly, this case was determined to be "▲". When the substrate-target distance D=60mm and D=75mm (Figures 7 and 8), perovskite crystals having an excellent crystalline orientation can be stably obtained. Accordingly, this case was determined to be "•".

Analysis of the composition of the piezoelectric film shown in Figure 7 (D=60mm:Nb-PZT film) was carried out by an XRF. As a result, it has been confirmed that the piezoelectric film was Nb-PZT film which was 1.02 in the ratio Pb/(Zr+Ti+Nb) of the amount of Pb in moles to the sum of the amount of the B site elements in moles and free from the Pb loss.

Piezoelectric constant $d_{31}$ of the piezoelectric film was measured by cantilever method by forming Pt upper electrode in thickness of 100nm on the Nb-PZT film by sputtering. Those formed with the substrate-target distance D=60mm (orientation 100) was high in the piezoelectric constant $d_{31}$ (250pm/V) and excellent.

When piezoelectric constant $d_{31}$ of the PZT film (D=100mm) including a somewhat pyrochlore phase was measured by a similar method, the piezoelectric constant $d_{31}$ was 110pm/V.

(Embodiment 2)

PZT film was formed in the same as in the embodiment except that the film-forming temperature Ts=420°C and the substrate-target distance D=60mm.

Under these conditions, perovskite crystals having an excellent crystalline orientation could be obtained though including somewhat pyrochlore phases.

(summary of embodiments 1 and 2)

Figure 11 is a view where XRD was measured for all the samples in the embodiments 1 and 2 and other samples and the result of XRD measurement is plotted with the film-forming temperature Ts and the substrate-target distance D, respectively taken as the abscissa and the ordinate.

Figure 11 shows that a perovskite crystal which is less in pyrochlore phases can be stably grown, whereby a piezoelectric film which is of a high quality in the crystalline structure and the composition can be stably formed by setting the film-forming condition to satisfy the following formulae (1) and (2) or (3) and (4) in the PZT film or Nb-PZT film.

$$400 \leq Ts\,(^{\circ}C) \leq 500 \quad \cdots \quad (1)$$

$$30 \leq D\,(mm) \leq 80 \quad \cdots \quad (2)$$

$$500 \leq Ts\,(^{\circ}C) \leq 600 \quad \cdots \quad (3)$$

$$30 \leq D\,(mm) \leq 100 \quad \cdots \quad (4)$$

The piezoelectric film-forming method of the present invention is applicable when the film is to be grown by a vapor phase growth method using plasma, and is applicable to piezoelectric film for use in, for instance, an ink jet recording heads, ferroelectric memories (FRAM), and a pressure sensor.

**Claims**

1. A piezoelectric film forming process for forming a piezoelectric film (40) on a substrate (20), the piezoelectric film (40) including elements of a target that has composition based on the composition of the piezoelectric film (40) to be formed, by placing the target and the substrate (20) so as to face each other and by releasing the elements from the target by a vapor phase growth method using plasma, the process being **characterized in that** a condition for forming the piezoelectric film (40) is determined so as to satisfy the following formulas (1) and (2):

$$400 \leq Ts(^\circ C) \leq 500 \quad \cdots \quad (1)$$

$$30 \leq D(mm) \leq 80 \quad \cdots \quad (2)$$

wherein Ts (°C) and D(mm) respectively represent the film-forming temperature and the distance between the substrate and the target.

2. A piezoelectric film forming process for forming a piezoelectric film (40) on a substrate (20), the piezoelectric film (40) including elements of a target that has composition based on the composition of the piezoelectric film (40) to be formed, by placing the target and the substrate (20) so as to face each other and by releasing the elements from the target by a vapor phase growth method using plasma, the process being **characterized in that** a condition for forming the piezoelectric film (40) is determined so as to satisfy the following formulas (3) and (4):

the following formulae (3) and (4) are satisfied.

$$500 \leq Ts(^\circ C) \leq 600 \quad \cdots \quad (3)$$

$$30 \leq D(mm) \leq 100 \quad \cdots \quad (4)$$

wherein Ts (°C) and D(mm) respectively represent the film-forming temperature and the distance between the substrate (20) and the target.

3. A piezoelectric film forming process as defined in Claim 1 or 2 in which the film (40) is formed at a film-forming speed not lower than 0.5μm/h.

4. A piezoelectric film forming process as defined in any one of Claims 1 to 3 in which the vapor phase growth method is sputtering.

5. A piezoelectric film forming process as defined in any one of Claims 1 to 4 in which the piezoelectric film (40) comprises at least one kind of perovskite oxide (may include an unavoidable impurity).

6. A piezoelectric film forming process as defined in Claim 5 in which the piezoelectric film (40) comprises at least one kind of perovskite oxide (may include an unavoidable impurity) represented by the following general formula (P).

$$A_a B_b O_3 \qquad (P)$$

(wherein A represents at least one kind of elements forming the A site including Pb,
B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements,

O represents an oxygen atom and
a and b may deviate from 1.0 in the range where perovskite structure is formed though a and b are 1.0 by standard.)

7. A piezoelectric film forming process as defined in Claim 6 in which the at least one kind of perovskite oxide is represented by the following general formula (P-1).

$$Pb_a(Zr_{b1}Ti_{b2}X_{b3})\,O_3 \qquad (P\text{-}1)$$

(wherein X represents at least one kind of metal element selected from an element group consisting of the V and VI group elements, and a>0, b1>0, b2>0, b3≧0. Though a=1.0 and b1+b2+b3=1.0 by standard, these values may deviate from 1.0 in the range where perovskite structure is formed.)

8. A piezoelectric film (40) including at least one kind of perovskite oxide (may include an unavoidable impurity) represented by the following general formula (P), the piezoelectric film (40) **characterized by** being formed by placing a target that has composition based on the composition of the piezoelectric film (40) to be formed and a substrate (20) so as to face each other and by releasing elements of the target from the target by a vapor phase growth method using plasma to form the piezoelectric film (40) including the elements of the target, wherein the following formulae (1) and (2) are satisfied:

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard. )

$$400 \leqq Ts\,(^\circ C) \leqq 500 \quad \cdots \quad (1)$$

$$30 \leqq D\,(mm) \leqq 80 \quad \cdots \quad (2)$$

(wherein Ts (°C) and D(mm) respectively represent the film-forming temperature and the distance between the substrate (20) and the target.)

9. A piezoelectric film (40) including at least one kind of perovskite oxide (may include an unavoidable impurity) represented by the following general formula (P), the piezoelectric film (40) **characterized by** being formed by placing a target that has composition based on the composition of the piezoelectric film (40) to be formed and a substrate (20) so as to face each other and by releasing elements of the target from the target by a vapor phase growth method using plasma to form the piezoelectric film (40) including the elements of the target, wherein the following formulae (3) and (4) are satisfied:

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is formed though a and b are 1.0 by standard. )

$$400 \leqq Ts\,(^\circ C) \leqq 600 \quad \cdots \quad (3)$$

$$30 \leqq D\,(mm) \leqq 100 \quad \cdots \quad (4)$$

(wherein Ts (°C) and D(mm) respectively represent the film-forming temperature and the distance between the substrate (20) and the target.)

10. A piezoelectric film (40) as defined in Claim 8 or 9 in which the at least one kind of perovskite oxide is represented by the following general formula (P-1).

$$Pb_a(Zr_{b1}Ti_{b2}X_{b3})O_3 \qquad (P-1)$$

(wherein X represents at least one kind of metal element selected from an element group consisting of the V and VI group elements, and a>0, b1>0, b2>0, b3≥0. Though a=1.0 and b1+b2+b3=1.0 by standard, these values may deviate from 1.0 in the range where perovskite structure is formed.)

11. A piezoelectric film (40) as defined in any one of Claims 8 to 10 in which 1.0≤a.

12. A piezoelectric film (40) as defined in Claim 11 in which 1.0≤a≤1.3.

13. A piezoelectric element (2) comprising a piezoelectric film (40) as defined in any one of Claims 8 to 12 and an electrode (30, 50) for applying an electric field to the piezoelectric film (40).

14. A liquid discharge system (3) comprising
the piezoelectric element (2) as defined in Claim 13 and
a liquid storing/discharging member(70) comprising a liquid storing chamber (71) in which liquid is stored and a liquid discharge port (72) through which the liquid is externally discharged.

FIG.1A

FIG.1B

# FIG.2

# FIG.3

EP 1 906 466 A1

# FIG.4

# FIG.5

FIG.6

FIG.7

FIG.8

# FIG.9

# FIG.10

FIG.11

FILM FORMING TEMPERATURE Ts (°C)

EP 1 906 466 A1

European Patent Office

# EUROPEAN SEARCH REPORT

Application Number

EP 07 01 8953

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG M-C ET AL: "Characteristics and crystal structure of the Ba(ZrxTi1-x)03 thin films deposited by RF magnetron sputtering" JOURNAL OF CRYSTAL GROWTH, ELSEVIER, AMSTERDAM, NL, vol. 246, no. 1-2, December 2002 (2002-12), pages 99-107, XP004391283 ISSN: 0022-0248 * the whole document * * table 2 * | 1-5 | INV. H01L41/24 H01L41/09 B41J2/14 C23C14/34 C23C14/08 |
| X | KANG YOUN-SEON ET AL: "Fabrication and current-voltage characterization of a ferroelectric lead zirconate titanate/AlGaN/GaN field effect transistor" APPLIED PHYSICS LETTERS, AIP, AMERICAN INSTITUTE OF PHYSICS, MELVILLE, NY, US, vol. 88, no. 12, 21 March 2006 (2006-03-21), pages 123508(1)-123508(3), XP012080766 ISSN: 0003-6951 * pages 123508-2, column 1, paragraph 2 * | 2,4-12 | |
| X | CHOI W S ET AL: "The effect of cerium doping in barium zirconate titanate thin films deposited by rf magnetron sputtering system" MATERIALS SCIENCE AND ENGINEERING B, ELSEVIER SEQUOIA, LAUSANNE, CH, vol. 109, no. 1-3, 15 June 2004 (2004-06-15), pages 146-151, XP004507190 ISSN: 0921-5107 * table 1 * | 1,2,4,5 | |

TECHNICAL FIELDS SEARCHED (IPC)

C23C
H01L
B41J

-/--

The present search report has been drawn up for all claims

| Place of search | Date of completion of the search | Examiner |
|---|---|---|
| Munich | 7 February 2008 | Meul, Hans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

# EUROPEAN SEARCH REPORT

Application Number

EP 07 01 8953

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHU T J ET AL: "Pulsed laser deposition of lead-zirconate-titanate thin films and multilayered heterostructures" APPLIED PHYSICS A; MATERIALS SCIENCE & PROCESSING, SPRINGER-VERLAG, BE, vol. 81, no. 4, 1 September 2005 (2005-09-01), pages 701-714, XP019336930 ISSN: 1432-0630 * figures 1,2,4 * | 1,2,5-9 | |
| X | US 6 300 212 B1 (INOUE NAOYA [JP] ET AL) 9 October 2001 (2001-10-09) * column 10, lines 11-35 * | 2,4,6-9 | |
| X | EP 1 560 279 A (MATSUSHITA ELECTRIC IND CO LTD [JP]) 3 August 2005 (2005-08-03) * paragraphs [0002], [0015], [0036], [0067], [0147]; example 1 * | 8-14 | |
| | | | TECHNICAL FIELDS SEARCHED (IPC) |

The present search report has been drawn up for all claims

| Place of search | Date of completion of the search | Examiner |
|---|---|---|
| Munich | 7 February 2008 | Meul, Hans |

EPO FORM 1503 03.82 (P04C01)

## ANNEX TO THE EUROPEAN SEARCH REPORT
## ON EUROPEAN PATENT APPLICATION NO.

EP 07 01 8953

This annex lists the patent family members relating to the patent documents cited in  the above-mentioned European search report.
The members are as contained in the European Patent Office EDP file on
The European Patent Office is in no way liable for these particulars which are merely given for the purpose of information.

07-02-2008

| Patent document cited in search report | | Publication date | Patent family member(s) | | Publication date |
|---|---|---|---|---|---|
| US 6300212 | B1 | 09-10-2001 | JP | 11054721 A | 26-02-1999 |
| EP 1560279 | A | 03-08-2005 | CN<br>DE<br>US | 1661827 A<br>602005002060 T2<br>2005162047 A1 | 31-08-2005<br>13-12-2007<br>28-07-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6049638 A

- JP 2005350735 A

**Non-patent literature cited in the description**

- Fabrication Process of New Ceramic Thin Films -Epltaxial Growth of Compound Thin Films. *Ceramics,* 1986, vol. 21 (2), 119-125